# EUROPÄISCHE PATENTSCHRIFT

(11) **EP 2 949 191 B1**
(45) Veröffentlichungstag und Bekanntmachung des Hinweises auf die Patenterteilung: **26.04.2017**
(21) Anmeldenummer: 14701043.3
(22) Anmeldetag: 21.01.2014
(51) Int. Cl.: H05K 7/20

(54) **WECHSELRICHTER MIT ZWEITEILIGEM GEHÄUSE**
INVERTER HAVING TWO-PART HOUSING
ONDULEUR POURVU D'UN BOÎTIER EN DEUX PARTIES

(30) Priorität: 22.01.2013 DE 102013100607
(43) Veröffentlichungstag der Anmeldung: 02.12.2015
(73) Patentinhaber: SMA Solar Technology AG, 34266 Niestetal (DE)
(72) Erfinder: DONTH, Andreas, 34295 Edermünde (DE); LISITSCHEW, Swetlana, 80639 München (DE); DITTMAR, Jens, 34329 Nieste (DE)
(74) Vertreter: Lahnor, Peter
(86) Internationale Anmeldenummer: PCT/EP2014/051091
(87) Internationale Veröffentlichungsnummer: WO 2014/114622

(56) Entgegenhaltungen:
- WO-A1-2010/091445
- DE-U1-212007 000 057
- US-A1- 2012 261 100
- US-A1- 2012 262 968

## Beschreibung

### TECHNISCHES GEBIET DER ERFINDUNG

Die Erfindung bezieht sich auf einen Wechselrichter mit einem Gehäuse, das ein erstes Gehäusemodul, ein mit dem ersten Gehäusemodul lösbar verbundenes zweites Gehäusemodul und einen in die Umgebung des Wechselrichters mündenden Kühlluftkanal aufweist, und mit leistungselektronischen Bauteilen in beiden Gehäusemodulen.

Insbesondere betrifft die Erfindung einen Wechselrichter, mit dem elektrische Energie von einem Photovoltaikgenerator dezentral in ein Wechselstromnetz eingespeist wird.

### STAND DER TECHNIK

Aus der EP 2 006 988 A1 ist ein Wechselrichter mit einem Gehäuse bekannt, das mindestens zwei Gehäusekammern umfasst. Die beiden Gehäusekammern sind in einem gemeinsamen Grundkörper des Gehäuses ausgebildet und jeweils durch einen gesonderten Deckel verschließbar. Leistungselektronische Bauteile des Wechselrichters sind dabei in einer ersten der beiden Gehäusekammern untergebracht, während Anschlussstecker und eine Kommunikationseinheit in der zweiten Gehäusekammer untergebracht sind. Auf diese Weise ist es nicht erforderlich, dass für Anschlussarbeiten der Deckel der ersten Gehäusekammer geöffnet wird, die eine höhere Schutzklasse aufweisen kann als die zweite Gehäusekammer. So ist die erste Gehäusekammer nach dieser Schutzklasse besonders gegen Umwelteinflüsse, insbesondere gegen Feuchtigkeit geschützt. Von der zweiten Gehäusekammer führt mindestens eine elektrische Verbindung in die erste Gehäusekammer, die die Schutzklasse der ersten Gehäusekammer aufweist. Die elektrische Verbindung umfasst eine Steckerbuchse, die in der Wandung zu der ersten Gehäusekammer angeordnet ist und der Aufnahme eines Steckers dient.

Aus der US 2001/0015583 A1 ist ein Wandler für einen elektrischen Motor oder Transformator bekannt. Der Wandler weist eine Verbindungsbox mit Passagen für elektrische Leiter und ein Halbleiterelektronikmodul auf, dass an der Verbindungsbox befestigt ist. Das Halbleiterelektronikmodul weist eine einen Radiator ausbildende Box auf, wobei mindestens eine elektronische Karte mit thermisch leitfähigem Harz in der den Radiator ausbildenden Box vergossen ist. Aus dem Harz steht mindestens ein Anschuss vor, der über ein Fenster in der Verbindungsbox zugänglich ist.

Aus der US 2006/0120001 A1 ist ein modularer Wechselrichter bekannt, bei dem im wesentlichen gleichbleibende Wechselrichterfunktionen und anwendungsspezifische Komponenten auf unterschiedliche Module verteilt sind. Die Module können in einem oder mehreren Gehäusemodulen angeordnet sein. Durch jedes Gehäusemodul verläuft ein an ein Gebläse angeschlossener Kühlluftkanal, an den die in dem Gehäusemodul angeordneten Module des Wechselrichters nacheinander angrenzen. Von einzelnen Modulen ragen Kühlkörper in den Kühlluftkanal hinein.

Aus der WO 2011/153564 ist ein Wechselrichter mit einem oberen und einem unteren Gehäuseteil bekannt, in denen elektronische Komponenten angeordnet sind und die über ein mehrteiliges Kontaktierungssystem lösbar elektrisch miteinander verbunden sind. Das untere Gehäuseteil ist zur ortfesten Montage und zum Anschließen des Wechselrichters vorgesehen. Durch die Trennbarkeit der beiden Gehäuseteile muss vom Monteur während der Montage nur das geringere Gewicht des unteren Gehäuseteils abgestützt werden. Das obere Gehäuseteil weist hingegen die wesentlichen elektronischen Komponenten und damit auch die Masse des Wechselrichters auf und wird erst später mit dem unteren Gehäuseteil verbunden. Auch ein Austausch des oberen Gehäuseteils und der darin angeordneten elektronischen Komponenten ist so einfach möglich. Allerdings ist die mechanische und elektrische Verbindung der beiden Gehäuseteile über ein Drehelement aufwändig und führt zu einer erheblichen Belastung der Verbindungsteile und Dichtungen zwischen den beiden Gehäuseteilen beim Verbinden und Trennen. Ein Kühlluftkanal ist bei diesem bekannten Wechselrichter in herkömmlicher Weise auf der Rückseite des unteren Gehäuseteils angeordnet und wird so in montiertem Zustand des Wechselrichters von dessen Abstützfläche und dem unteren Gehäuseteil begrenzt. In diesen Kühlkanal ragen Kühlkörper von dem unteren Gehäuseteil hinein.

Aus der DE 10 2010 017 168 A1 ist eine Kühlanordnung zum Kühlen Wärme erzeugender Bauteile, insbesondere von Leistungselektronikbauteilen, bekannt. Dabei ist unterhalb einer abnehmbaren Vorderwand eine Druckkammer definiert, zu der wenigstens zwei Einlasskanäle führen. In jedem dieser Einlasskanäle ist ein Lüfter vorgesehen, um Luft anzusaugen und durch den Einlasskanal in die Druckkammer zu treiben. In jedem der Einlasskanäle ist ein Kühlkörper angeordnet, der einen Kühlkörperkanal für durchströmende Luft bildet und der den Einlasskanal mit der Druckkammer verbindet. Weiterhin ist wenigstens ein Auslasskanal vorgesehen, der von der Druckkammer wegführt, um die von den Lüftern durch die Einlasskanäle und die Kühlkörperkanäle getriebene Luft austreten zu lassen. Beim Ausfall eines Lüfters wird eine Umkehrung der Luftströmungsrichtung durch den dem ausgefallenen Lüfter zugeordneten Einlasskanal bewirkt, um den angeschlossenen Kühlkörperkanal weiterhin mit Luft zu durchströmen. Die Leistungselektronikbauteile, bei denen es sich um diejenigen eines Wechselrichters handeln kann, können auf den Kühlkörpern der Kühlanordnung montiert sein. Die Lufteinlässe sind bei Anwendungen im Außenbereich mit Gittern oder Sieben versehen, um vor groben Verunreinigungen zu schützen.

Aus der DE 10 2011 000 706 A1 ist eine Wechselrichtervorrichtung mit einer Leistungseinheit bekannt. Die Leistungseinheit weist Halbleitermodule und Kühlkörper auf, wobei die Kühlkörper zu beiden Seiten jedes Halbleitermoduls und in einem Lüftungsweg für Kühlluft angeordnet sind. Die Wechselrichtervorrichtung ist in ein Fahrzeug mit einem Wechselstrommotor verbaut.

Aus der DE 43 16 999 A1 ist eine Vorrichtung zur Wärmeabfuhr aus einem Innenraum eines Schaltschranks einer Textilmaschine bekannt, der durch den Betrieb elektrischer und elektronischer Geräte erwärmt wird. Dabei sind Kühlkörper der elektrischen und elektronischen Geräte in einem Kühlluftkanal angeordnet, und im Kühlluftkanal geförderte Kühlluft strömt die Oberfläche der Kühlkörper entlang. Entsprechend den Merkmalen des Oberbegriffs des unabhängigen Patentanspruchs 1 sind Wechselrichtermodule so in Schubfächer eines Schaltschrankes eingeschoben, dass in deren Endlage die Kühlkörper in jedem Schubfach ein Segment des zwischen ihnen verlaufenden Kühlluftkanals bilden.

Die US 2012/0262968 A1 offenbart ein Leistungswandlergehäuse, bei dem ein einzelner vor dem Eindringen von Luft Schmutz und Wasser geschützter Bereich mit Leistungselektronik derart montiert ist, dass ein außen am geschützten Bereich angebrachter Kühlkörper in einen durch das Innere des Gehäuses führenden Luftstrom ragt, während die Schrift US 2012/0261100 A1 einen Gehäuseaufbau für einen Leistungswandler mit einem geschlossenem Bereich mit Halbleiterbauelementen offenbart, bei dem eine ausgeglichene Wärmeabfuhr über zwei Kühlluftkanäle erfolgt.

### AUFGABE DER ERFINDUNG

Der Erfindung liegt die Aufgabe zugrunde, einen Wechselrichter aufzuzeigen, der auch im Außenbereich einfach zu montieren ist und der im Falle eines Defekts dennoch einfach instand zu setzen ist.

### LÖSUNG

Die Aufgabe der Erfindung wird durch einen Wechselrichter mit dem Merkmal des unabhängigen Patentanspruchs 1 gelöst. Bevorzugte Ausführungsformen des erfindungsgemäßen Wechselrichters sind in den abhängigen Patentansprüchen definiert.

### BESCHREIBUNG DER ERFINDUNG

Die Erfindung betrifft einen Wechselrichter mit einem ersten Gehäusemodul, einem mit dem ersten Gehäusemodul lösbar verbundenen zweiten Gehäusemodul und leistungselektronischen Bauteilen in beiden Gehäusemodulen, bei dem ein in die Umgebung des Wechselrichters mündender Kühlluftkanal in Umfangsrichtung zum Teil von dem ersten Gehäusemodul und zum Teil von dem zweiten Gehäusemodul begrenzt wird. Erfindungsgemäß ist das erste Gehäusemodul zur Montage an einer externen Struktur und das zweite Gehäusemodul zur ausschließlichen Montage an dem ersten Gehäusemodul ausgebildet. Der Kühlluftkanal verläuft dabei in einem Abstand zu einer von dem ersten Gehäusemodul gegenüber der externen Struktur definierten Montageebene des Wechselrichters, wobei die leistungselektronischen Bauteile hinter den Kühlluftkanal begrenzenden Wandungen des ersten Gehäusemoduls und des zweiten Gehäusemoduls und damit geschützt in den Gehäusemodulen angeordnet sind.

Der Kühlluftkanal kann offen sein, d. h. an einer Seite seines Umfangs ohne Begrenzung durch das Gehäuse sein. Eine besonders wirksame Luftführung und bei passiver Durchströmung ein besonders wirksamer Kamineffekt bilden sich in dem Kühlluftkanal jedoch aus, wenn der Kühlluftkanal in Umfangsrichtung geschlossen ist. Unter einem geschlossenen Kühlluftkanal wird hier ein Kühlluftkanal verstanden, der zumindest über einen Bereich seiner Erstreckung in Durchströmungsrichtung vollständig, d. h. über seinen gesamten Umfang um diese Durchströmungsrichtung, von dem Gehäuse des Wechselrichters umschlossen ist. Dabei müssen nicht über den gesamten Umfang des Kühlluftkanals Innenräume oder Bereiche im Inneren der Gehäusemodule an die Rückseiten der Wandungen der Gehäusemodule angrenzen, die den Kühlluftkanal begrenzen. Über einen Teil seines Umfangs kann der Kühlluftkanal auch nur über von dem ersten oder zweiten Gehäusemodul abstehenden Wandsegmente oder Kühlrippen begrenzt sein.

Indem der Kühlluftkanal bei dem erfindungsgemäßen Wechselrichter teilweise von dem ersten Gehäusemodul und teilweise von dem zweiten Gehäusemodul begrenzt wird, können sowohl die in dem ersten Gehäusemodul als auch die in dem zweiten Gehäusemodul angeordneten leistungselektronischen Bauteile von einem Kühlluftstrom durch den Kühlluftkanal gekühlt werden. Die leistungselektronischen Bauteile sind dabei jedoch nicht in dem Kühlluftkanal sondern hinter den den Kühlluftkanal begrenzenden Wandungen der beiden Gehäusemodule und damit geschützt in den Gehäusemodulen angeordnet.

Dass der Kühlluftkanal in Umfangrichtung zum Teil von dem ersten und zum Teil von dem zweiten Gehäusemodul begrenzt wird, bedeutet nicht, dass der Kühlluftkanal in längs seiner Durchströmungsrichtung aufeinander folgenden Abschnitten durch das erste und das zweite Gehäusemodul verläuft, sondern dass der Kühlluftkanal durch das Zusammenfügen der beiden Gehäusemodule teilweise oder ganz umschlossen wird. Die Wandungen oder Bereiche des ersten Gehäusemoduls, die den Kühlluftkanal zum Teil begrenzen, sind daher dem zweiten Gehäusemodul zugewandt und umgekehrt, und es gibt zusätzlich mindestens einen Bereich, bei einem ganz umschlossenen Kühlluftkanal zwei Bereiche, in denen das erste und das zweite Gehäusemodul am Umfang des Kühlluftkanals aneinanderstoßen.

Indem der Kühlluftkanal bei dem erfindungsgemäßen Wechselrichter zwischen dem ersten und dem zweiten Gehäusemodul hindurch verläuft, verläuft er im Abstand zu der von dem ersten Gehäusemodul gegenüber der externen Struktur, an der das erste Gehäusemodul zu montieren ist, definierten Montageebene des Wechselrichters. Der Kühlkanal vieler herkömmlicher Wechselrichter ist hingegen im Bereich dieser Montageebene angeordnet. Derartige Kühlkanäle herkömmlicher Wechselrichter werden jedoch oft durch in derselben Montageebene montierte oder verlaufende Objekte zumindest teilweise blockiert. Der Verlauf des Kühlkanals des erfindungsgemäßen Wechselrichters verbessert daher die Voraussetzungen für die unbehinderte Durchströmung des Kühlluftkanals mit Kühlluft. Auf diese Weise lässt sich eine ausreichende Kühlung der leistungselektronischen Bauteile des Wechselrichters oftmals schon allein auf Basis einer freien, rein konvektionsbedingten Strömung und ohne einen Einsatz von Lüftern zur Erzeugung einer erzwungenen Kühlluftströmung erzielen. Zumindest ist jedoch die Kühlwirkung eines von der Montageebene beabstandeten Kühlluftkanals aufgrund des dort im Allgemeinen niedrigeren Strömungswiderstandes gegenüber der Kühlwirkung eines Kühlluftkanals, der im Bereich der Montageebene angeordnet ist, deutlich optimiert.

Das erste Gehäusemodul und/oder das zweite Gehäusemodul können bei dem erfindungsgemäßen Wechselrichter jeweils mindestens einen in den Kühlkanal vorspringenden Kühlkörper umfassen. Dabei ist unter einem Kühlkörper typischerweise eine Anordnung von Kühlrippen zu verstehen, die von der den Kühlkanal begrenzenden Wandung des ersten bzw. zweiten Gehäusemoduls abstehen und sich längs der Durchströmungsrichtung des Kühlkanals erstrecken. Grundsätzlich können sich die Kühlkörper von beiden Gehäusemodulen im selben Abschnitt längs der Durchströmungsrichtung des Kühlluftkanals in den Kühlluftkanal hinein erstrecken. Dabei können sich die Kühlrippen der Kühlkörper beider Gehäusemodule gegenüber stehen oder versetzt zueinander angeordnet sein und in dem Kühlkanal sogar kammartig ineinandergreifen. Insbesondere im letzteren Fall ist jedoch darauf zu achten, dass genügend freie Bereiche zwischen den Kühlrippen verbleiben, die ein Durchströmen mit Kühlluft gewährleisten. Dies kann eine Verringerung der Anzahl der Kühlrippen an beiden Gehäusemodulen erfordern. Zum Erhalt eines möglichst geringen und gleichmäßigen Strömungswiderstands der Luftströmung durch den Kühlluftkanal ist es jedoch häufig bevorzugt, wenn die Kühlkörper von den beiden Gehäusemodulen in unterschiedlichen Bereichen, insbesondere in unterschiedlichen Abschnitten längs der Durchströmungsrichtung in den Kühlkanal vorspringen.

Die Kühlrippen beider Gehäusemodule können im zusammengebauten Zustand des Wechselrichters voneinander beabstandet sein oder sich in direktem Kontakt miteinander befinden. Es können auch nur einzelne Kühlrippen innerhalb des Kühlkanals in direktem Kontakt miteinander stehen. Ein direkter mechanischer Kontakt zumindest einzelner Kühlrippen beider Gehäusemodule führt dazu, dass neben einer Wärmeabführung mithilfe der hindurchströmenden Kühlluft auch eine Wärmeleitung zwischen den Kühlrippen beider Gehäusemodule erfolgt. Dieser Effekt ermöglicht einen zusätzlichen Wärmeausgleich zwischen beiden Gehäusemodulen und wirkt daher einer übermäßigen Erwärmung nur eines Gehäusemoduls entgegen. Durch miteinander in Kontakt stehenden Kühlrippen kann der Kühlluftkanal zwischen dem ersten und dem zweiten Gehäusemodul auch ganz oder teilweise geschlossen werden. Um die Kühlkörper maximal zu nutzen, sind zu kühlende leistungselektronische Bauteile in den beiden Gehäusemodulen in möglichst engem thermischen Kontakt zu den Kühlkörpern anzuordnen.

Sowohl das erste Gehäusemodul als auch das zweite Gehäusemodul weist vorzugsweise jeweils mindestens eine Aufnahme zur direkten ortsfesten Lagerung eines oder mehrerer der leistungselektronischen Bauteile auf, um diese maximal thermisch an den Kühlluftkanal anzukoppeln. D. h. diese Aufnahmen sind vorzugsweise auf der der Kühlluft abgekehrten Seite von Wandungen der Gehäusemodule vorgesehen, die den Kühlluftkanal begrenzen.

Wenn das erste Gehäusemodul und/oder das mit dem ersten Gehäusemodul lösbar verbundene zweite Gehäusemodul, optional zusammen mit weiteren Gehäusemodulen, mindestens einen Bereich für eines oder mehrere der leistungselektronischen Bauteile gegenüber der Umgebung abdichtet bzw. abdichten, kann dieser Bereich gemäß einer hohen Schutzklasse ausgebildet sein, und der Wechselrichter kann beispielsweise auch für einen Einsatz im ungeschützten Außenbereich geeignet sein. Jedes der beiden Gehäusemodule kann einen oder mehrere allein durch dieses Gehäusemodul abgedichtete Bereiche umfassen. Alle Gehäusemodule können aber auch zusammen, d. h. erst in ihrem zusammengefügten Zustand, einen oder mehrere Bereiche abdichten.

Zwischen dem ersten Gehäusemodul und dem zweiten Gehäusemodul können lösbare elektrische Verbindungen, wie insbesondere elektrische Steckverbindungen zur wechselseitigen Kontaktierung der leistungselektronischen Bauteile in den beiden Gehäusemodulen vorgesehen sein. Diese Steckverbindungen können automatisch beim Zusammenfügen der beiden Gehäusemodule geschlossen werden. Die elektrischen Verbindungen können aber auch zum separaten Schließen im zusammengefügten Zustand der Gehäusemodule ausgebildet sein.

Zum Abdichten eines zusammenhängenden Bereichs zwischen dem ersten Gehäusemodul und dem zweiten Gehäusemodul gegenüber der Umgebung kann zwischen dem ersten Gehäusemodul und dem zweiten Gehäusemodul mindestens eine Dichtung angeordnet sein. Diese Dichtung kann beim Zusammenfügen der beiden Gehäusemodule mit der notwendigen Dichtkraft beaufschlagt werden. Dabei kann der zusammenhängende Bereich auch ein sich durch das erste Gehäusemodul und das zweite Gehäusemodul erstreckender Kühlmittelkanal für ein flüssiges Kühlmittel sein. Mit dem Kühlmittel kann die im Inneren der Gehäusemodule anfallende Wärme gezielt an an den Kühlluftkanal angrenzende Kühlkörper oder auch an eine zusätzliche externe Wärmesenke abgegeben werden. Innerhalb jedes Gehäusemoduls oder eines sich zusammenhängend über mehrere Gehäusemodule erstreckenden Bereichs kann abzuführende Wärme auch durch Umwälzen von Kühlluft mit einem Lüfter transportiert werden.

Bei dem erfindungsgemäßen Wechselrichter können zwischen den Gehäusemodulen mechanische Linearführungen zur wechselseitigen Ausrichtung beim linearen, d. h. geradlinigen Zusammenfügen der Gehäusemodule vorgesehen sein. Dabei kann es sich zum Beispiel um an dem ersten Gehäusemodul verankerte Führungsstangen handeln, auf die Führungsbuchsen des zweiten Gehäusemoduls aufgeschoben werden. Die wechselseitige Ausrichtung der Gehäusemodule durch die Linearführungen sorgt dafür, dass die Gehäusemodule in gewünschter Relativanordnung zusammengefügt werden und dazwischen befindliche Dichtungen aber auch Steckverbindungen nur in vorgesehenen Richtungen beaufschlagt bzw. verpresst werden. Insbesondere ist durch die Linearführungen beim Zusammenbau des Wechselrichters eine abrasiv wirkende Relativbewegung zwischen der Dichtung bzw. den Dichtungen und den ihnen gegenüberliegenden abdichtenden Flächen weitestgehend eliminiert. Auf diese Weise werden die Dichtungen beim Zusammenbau des Wechselrichters nicht beschädigt.

Bei dem erfindungsgemäßen Wechselrichter ist nur das erste Gehäusemodul zur Montage an einer externen Struktur, wie beispielsweise einer Wand oder einem Traggestell, und das zweite Gehäusemodul zur ausschließlichen Montage an dem ersten Gehäusemodul vorgesehen. D. h. die Wandverankerung des erfindungsgemäßen Wechselrichters erfolgt durch Montage des ersten Gehäusemoduls. Entsprechend muss dabei vom Monteur auch nur das erste Gehäusemodul gegen seine Gewichtskraft abgestützt werden. Das zweite Gehäusemodul wird erst anschließend an dem ersten Gehäusemodul montiert und dabei ggf. bereits von zwischen den Gehäusemodulen vorgesehenen Linearführungen abgestützt. In jedem Fall muss der Monteur während der Montage niemals die Masse des gesamten Wechselrichters halten.

In dem ersten Gehäusemodul des erfindungsgemäßen Wechselrichters können zum einen DC-Anschlüsse und/oder DC-Trennschalter, die dem Eingang des Wechselrichters zugeordnet sind, ebenso wie AC-Anschlüsse und/oder AC-Trennschalter, die dem Ausgang des Wechselrichters zugeordnet sind, angeordnet sein. Damit kann der gesamte Anschluss des Wechselrichters an den jeweiligen Eingang und Ausgang an dem zuerst montierten ersten Gehäusemodul erfolgen. Weiterhin können in dem ersten Gehäusemodul alle mit besonders hoher Masse behafteten leistungselektronischen Bauteile angeordnet werden, insbesondere Wickelgüter. Diese leistungselektronischen Bauteile zeichnen sich in aller Regel nicht nur durch eine hohe Masse, sondern auch eine besonders geringe Fehleranfälligkeit aus. Vielfach werden sie daher von einer Instandsetzung eines fehlerbehafteten Wechselrichters durch Austausch von Bauteilen nicht betroffen sein. Damit ist dann das gesamte erste Modul von einem solchen Austausch nicht betroffen, der sich auf das zweite Gehäusemodul beschränken kann. Entsprechend sind in dem zweiten Gehäusemodul vorzugsweise Platinen einer Leistungselektronik und/oder Schalter einer Wechselrichterbrücke und/oder Platinen einer Steuerelektronik angeordnet. Aufgrund der Komplexität dieser Bauteile erfolgt eine Reparatur bzw. ein Austausch einzelner von einem Fehler betroffener Komponenten vor Ort eher selten. Eine Reparatur bzw. ein Austausch einzelner von einem Fehler betroffener Komponenten vor Ort ist mitunter sogar unerwünscht, da aufgrund der vor Ort oftmals nicht ausreichend kontrollierbaren Rahmenbedingungen die Gefahr besteht weiteren Schaden anzurichten. Daher ist erwünscht, dass ein Austausch empfindlicher Bauteile unter kontrollierbaren Bedingungen direkt beim Hersteller erfolgt. Dort kann das Gerät samt seinen ausgetauschten Bauteilen vor erneuter Inbetriebnahme zudem intensiv getestet werden. Bei einem Defekt einzelner komplexer Bauteile ist es somit im Allgemeinen ratsam, das betroffene Gehäusemodul insgesamt gegen ein funktionsfähiges Gehäusemodul auszutauschen und die Reparatur der defekten Komponenten im Anschluss daran direkt beim Hersteller durchzuführen. Diese leistungselektronischen Bauteile sind zudem regelmäßig mit einer deutlich geringeren Masse behaftet als beispielsweise Wickelgüter, so dass das zweite Gehäusemodul des erfindungsgemäßen Wechselrichters tendenziell leichter als das erste Gehäusemodul ist.

Bei dem erfindungsgemäßen Wechselrichter werden also die großen Massen in dem ersten Gehäusemodul direkt an der tragenden Struktur abgestützt und danach nicht mehr bewegt, während die kleineren und daher leichter zu handhabenden Massen in dem zweiten und etwaigen weiteren Gehäusemodulen bedarfsweise an das erste Gehäusemodul an und von diesem abgebaut werden.

Das erste Gehäusemodul und/oder das zweite Gehäusemodul weisen vorzugsweise jeweils einen Grundkörper aus Metall auf, der ihren den Kühlluftkanal begrenzenden Teil umfasst. Durch das Metall wird eine besonders schnelle Wärmeübertragung an den Kühlluftkanal und auf die darin strömende Kühlluft erreicht. Vorzugsweise bestehen die beiden Gehäusemodule jeweils im Wesentlichen aus diesem Grundkörper aus Metall. In einer Ausführungsform sind diese Grundkörper durch ein Druckgussverfahren hergestellt. Hierbei sind die Kühlrippen inhärenter Bestandteil der Grundkörpers, da sie durch das Druckgussverfahren mit ausgeformt werden. Alternativ ist jedoch auch möglich, die Grundkörper auf Basis einer geschweißten Blechkonstruktion herzustellen. In diesem Fall sind die Kühlkörper mit den Kühlrippen separate Strangpressprofile, die im Nachhinein an den Grundkörper beispielsweise angeklebt, angepresst oder angeschweißt werden. Hierbei liegt es im Rahmen der Erfindung, den Wärmeübergang zwischen benachbarten separaten Komponenten durch bekannte Maßnahmen - beispielsweise Wärmeleitpaste - zu optimieren.

An das zweite Gehäusemodul kann auf seiner dem ersten Gehäusemodul gegenüberliegenden Seite mindestens ein weiteres Gehäusemodul angrenzen. Es können noch mehrere solche weiteren Gehäusemodule vorgesehen sein. Dabei ist es bevorzugt, wenn mindestens zwei solcher weiterer Gehäusemodule mit identischen Grundkörpern auf das zweite Gehäusemodul gestapelt sind. Diese Stapel können dann von einem Gehäusedeckel abgeschlossen werden. Wenn die weiteren Gehäusemodule nicht benötigt werden, kann dieser Gehäusedeckel auch zum direkten Verschluss des zweiten Gehäusemoduls verwendet werden. Dazu ist es bevorzugt, dass die dem ersten Gehäusemodul abgekehrten Öffnungen des zweiten Gehäusemoduls und aller weiteren Gehäusemodule identische Abmessungen aufweisen. Die Grundkörper der weiteren Gehäusemodule und der Gehäusedeckel können ebenfalls aus Metall, zur Gewichtseinsparung aber auch aus Kunststoff ausgebildet sein.

Der Kühlluftkanal des erfindungsgemäßen Wechselrichters kann an seinen beiden Enden, d. h. sowohl an seinem Eintritt in das Gehäuse als auch an seiner Mündung in die Umgebung des Wechselrichters offen sein; alternativ kann er an einem oder beiden dieser Enden an mindestens ein Kühlluftgebläse angeschlossen sein. Das heißt die Kühlung über den Kühlluftkanal kann rein passiv aufgrund des sich darin ausbildenden Kamineffekts oder mit Hilfe einer durch das Kühlluftgebläse hervorgerufenen Zwangsströmung erfolgen. Wenn der Kühlluftkanal passiv betrieben wird, wird er vorzugsweise vertikal ausgerichtet.

Wenn sich der Kühlluftkanal zwischen den beiden Gehäusemodulen Y- oder T-förmig nach oben verzweigt, während seine beiden oberen Enden seitlich an dem Gehäuse liegen, gelangt kein Niederschlag von oben in den Kühlluftkanal. Dies ist bei Montage des Wechselrichters im Außenbereich von Vorteil.

Bei einem Y- oder T-förmigen Kühlluftkanal können elektrische Verbindungen zwischen dem ersten Gehäusemodul und dem zweiten Gehäusemodul in einem abgedeckten Verbindungsbereich oberhalb des Kühlluftkanals angeordnet sein. Je nach Ausbildung der elektrischen Verbindungen muss der Verbindungsbereich keine besondere Schutzklasse aufweisen.

Der Kühlluftkanal eines erfindungsgemäßen Wechselrichters kann sich in seiner Breite über mehr als zwei Drittel der Breite des Gehäuses erstrecken und so sowohl das erste als auch das zweite Gehäusemodul über großflächige ihn begrenzende Wandungen kühlen.

Prinzipiell kann bei einem Gehäusemodul - insbesondere dem Gehäusemodul mit der höchsten abzuführenden Verlustwärme - oder auch allen Gehäusemodulen zusätzlich zu dem Kühlluftkanal eine Wasserkühlung oder eine andere Kühlung mit einem flüssigen Kühlmittel vorgesehen sein. Diese zusätzliche Kühlung kann im Bedarfsfall, zum Beispiel über eine geeignete Temperatursteuerung, zusätzlich zu der stets vorhandenen Luftkühlung zugeschaltet werden. Hierbei kann die zusätzliche Kühlung sowohl global auf das Gehäusemodul als auch nur auf lokal begrenzte Bereiche oder einzelne Komponenten desselben wirken. Vorteilhaft ist es, die zusätzliche Kühlung an dem ersten an einer externen Struktur montierten Gehäusemodul vorzusehen, da auf diese Weise ein Austausch des zweiten Gehäusemoduls nicht durch Anschlüsse für die zusätzliche Kühlung behindert wird.

Vorteilhafte Weiterbildungen der Erfindung ergeben sich aus den Patentansprüchen, der Beschreibung und den Zeichnungen. Die in der Beschreibung genannten Vorteile von Merkmalen und von Kombinationen mehrerer Merkmale sind lediglich beispielhaft und können alternativ oder kumulativ zur Wirkung kommen, ohne dass die Vorteile zwingend von erfindungsgemäßen Ausführungsformen erzielt werden müssen. Ohne dass hierdurch der Gegenstand der beigefügten Patentansprüche verändert wird, gilt hinsichtlich des Offenbarungsgehalts der ursprünglichen Anmeldungsunterlagen und des Patents Folgendes: weitere Merkmale sind den Zeichnungen - insbesondere den dargestellten Geometrien und den relativen Abmessungen mehrerer Bauteile zueinander sowie deren relativer Anordnung und Wirkverbindung - zu entnehmen. Die Kombination von Merkmalen unterschiedlicher Ausführungsformen der Erfindung oder von Merkmalen unterschiedlicher Patentansprüche ist ebenfalls abweichend von den gewählten Rückbeziehungen der Patentansprüche möglich und wird hiermit angeregt. Dies betrifft auch solche Merkmale, die in separaten Zeichnungen dargestellt sind oder bei deren Beschreibung genannt werden. Diese Merkmale können auch mit Merkmalen unterschiedlicher Patentansprüche kombiniert werden. Ebenso können in den Patentansprüchen aufgeführte Merkmale für weitere Ausführungsformen der Erfindung entfallen.

Die in den Patentansprüchen und der Beschreibung genannten Merkmale sind bezüglich ihrer Anzahl so zu verstehen, dass genau diese Anzahl oder eine größere Anzahl als die genannte Anzahl vorhanden ist, ohne dass es einer expliziten Verwendung des Adverbs "mindestens" bedarf. Wenn also beispielsweise von einem Element die Rede ist, ist dies so zu verstehen, dass genau ein Element, zwei Elemente oder mehr Elemente vorhanden sind. Diese Merkmale können durch andere Merkmale ergänzt werden oder die einzigen Merkmale sein, aus denen das jeweilige Erzeugnis besteht.

Die in den Patentansprüchen enthaltenen Bezugszeichen stellen keine Beschränkung des Umfangs der durch die Patentansprüche geschützten Gegenstände dar. Sie dienen lediglich dem Zweck, die Patentansprüche leichter verständlich zu machen.

### KURZBESCHREIBUNG DER FIGUREN

Im Folgenden wird die Erfindung anhand von in den Figuren dargestellten bevorzugten Ausführungsbeispielen weiter erläutert und beschrieben.
- **Fig. 1**: ist eine perspektivische Außenansicht eines erfindungsgemäßen Wechselrichters mit Blickrichtung schräg von vorne.
- **Fig. 2**: ist eine perspektivische Ansicht des Wechselrichters gemäß Fig. 1 mit Blickrichtung schräg von hinten.
- **Fig. 3**: ist eine separate perspektivische Ansicht eines ersten Gehäusemoduls des Wechselrichters gemäß den Fig. 1 und 2 mit Blickrichtung schräg von vorne.
- **Fig. 4**: ist eine perspektivische Ansicht des ersten Gehäusemoduls gemäß Fig. 3 mit Blickrichtung schräg von hinten.
- **Fig. 5**: ist eine Fig. 3 entsprechende perspektivische Ansicht des ersten Gehäusemoduls zusammen mit Linearführungen für und elektrischen Steckverbindungen zu anderen Gehäusemodulen.
- **Fig. 6**: ist eine perspektivische Ansicht eines zweiten Gehäusemoduls mit Blickrichtung schräg von vorne.
- **Fig. 7**: ist eine perspektivische Ansicht des Gehäusemoduls gemäß Fig. 6 mit Blickrichtung schräg von hinten.
- **Fig. 8**: zeigt das erste Gehäusemodul und das zweite Gehäusemodul im zusammengefügten Zustand zusammen mit den Linearführungen und Steckverbindungen gemäß Fig. 5, wobei das zweite Gehäusemodul transparent dargestellt ist, so dass die Linearführungen und Steckverbindungen auch in seinem Bereich sichtbar sind.
- **Fig. 9**: ist eine perspektivische Ansicht eines weiteren Gehäusemoduls des Wechselrichters mit Blickrichtung schräg von vorne.
- **Fig. 10**: ist eine perspektivische Ansicht eines Gehäusedeckels des Wechselrichters mit Blickrichtung schräg von hinten.
- **Fig. 11**: ist eine perspektivische Außenansicht auf das hier seinerseits zweiteilige und noch nicht zusammengebaute erste Gehäusemodul und das damit noch nicht verbundene zweite Gehäusemodul eines weiteren erfindungsgemäßen Wechselrichters mit Blickrichtung schräg von unten.
- **Fig. 12**: ist eine perspektivische Außenansicht auf das zweite Gehäusemodul des Wechselrichters gemäß Fig. 11 mit Blickrichtung schräg von hinten; und
- **Fig. 13**: ist eine perspektivische Außenansicht auf das zusammengebaute erste Gehäusemodul und das damit noch nicht verbundene zweite Gehäusemodul des Wechselrichters gemäß Fig. 11 mit geöffnetem Verbindungsbereich und anderer Blickrichtung schräg von unten als in Fig. 11.

### FIGURENBESCHREIBUNG

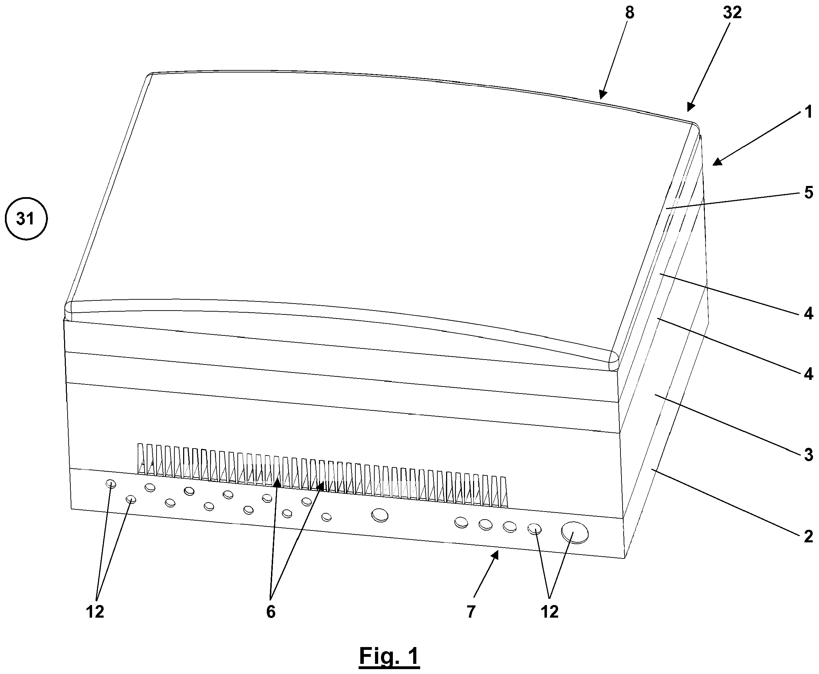

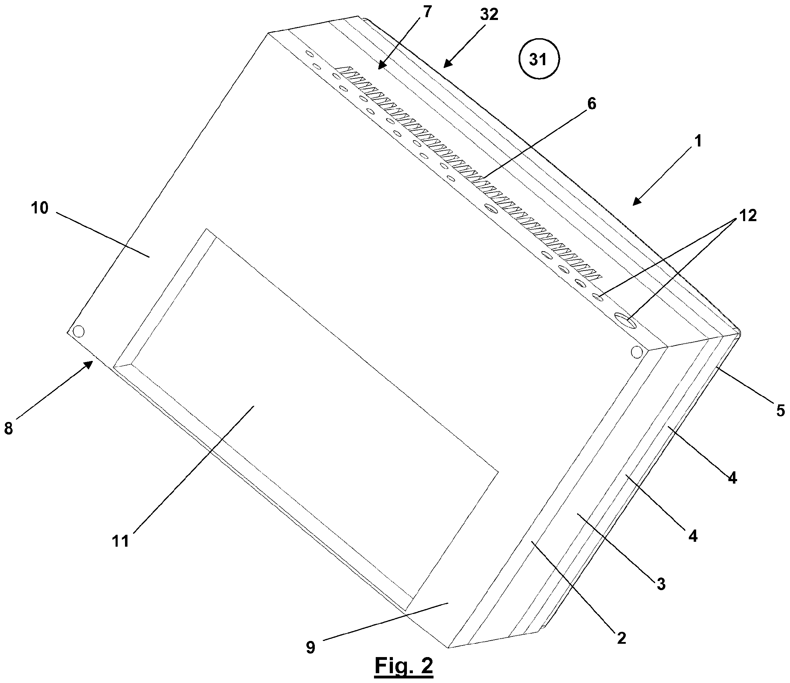

Der in den **Fig. 1** **und** **2** aus zwei Richtungen dargestellte Wechselrichter 1 weist ein Gehäuse 32 mit einem ersten, hinteren Gehäusemodul 2, einem daran anschließenden zweiten Gehäusemodul 3, zwei weitere von außen identischen Gehäusemodulen 4 und einem den Stapel der Gehäusemodule 2 bis 4 abschließenden Gehäusedeckel 5 auf. Zwischen dem ersten Gehäusemodul 2 und dem zweiten Gehäusemodul 3 verläuft dabei ein Kühlluftkanal 6. Der Kühlluftkanal 6 geht dabei von einer Seite 7 des Wechselrichters bis zur gegenüberliegenden Seite 8 des Wechselrichters im Wesentlichen geradlinig durch. Dabei kann die Seite 7 des Wechselrichters seine im Betrieb oben liegende Seite und die Seite 8 des Wechselrichters seine im Betrieb unten liegende Seite sein oder umgekehrt. Der Kühlluftkanal 6 ist so im Betrieb des Wechselrichters 1 vertikal ausgerichtet, und in dem Kühlluftkanal erwärmte Luft steigt infolge des Kamineffekts nach oben auf, tritt dort in die Umgebung 31 des Wechselrichters 1 aus und zieht dabei unten kühlere Luft aus der Umgebung 31 nach. Das hinten liegende erste Gehäusemodul 2 bildet mit seiner Rückwand 9 die Montageebene bei der Montage des Wechselrichters 1 an eine externe Struktur. Gegenüber dieser Montageebene ist der Kühlluftkanal 6 nach vorne versetzt. Die Durchströmung des Kühlluftkanals 6 mit Kühlluft wird so durch die externe Struktur und andere daran montierte Objekte nicht behindert. An der Rückseite 9 weist das Gehäusemodul 2 in seinem einstückig aus Metall ausgebildeten Grundkörper 10 eine Tasche 11 auf. In dieser Tasche 11 können z. B. Wickelkörper des Wechselrichters 1 angeordnet werden. Dabei kann die Tasche 11 durch eine hier nicht gezeigte Verschlussplatte dicht verschlossen sein, damit das Gehäuse 32 für diese Wickelkörper eine vorgegebene Schutzklasse erfüllt. Die Wickelkörper können auch mit einer Kunststoffmasse vergossen sein und müssen dann nicht zwingend in einem Bereich hoher Schutzklasse untergebracht werden. In diesem Fall muss die Tasche 11 nicht notwendigerweise dicht verschlossen sein. Öffnungen 12 in dem Grundkörper 10 an der Seite 7 dienen zur Durchführung von sowohl DC-seitigen als auch AC-seitigen Anschlussleitungen für den Anschluss des Wechselrichters 1 beispielsweise an einen Photovoltaikgenerator einerseits und ein Wechselstromnetz andererseits. Die weiteren Gehäusemodule 4 des Wechselrichters 1 können je nach Bestückung des Wechselrichters 1 entfallen. Es können auch noch zusätzliche weitere Gehäusemodule 4 auf das zweite Gehäusemodul 3 gestapelt sein.

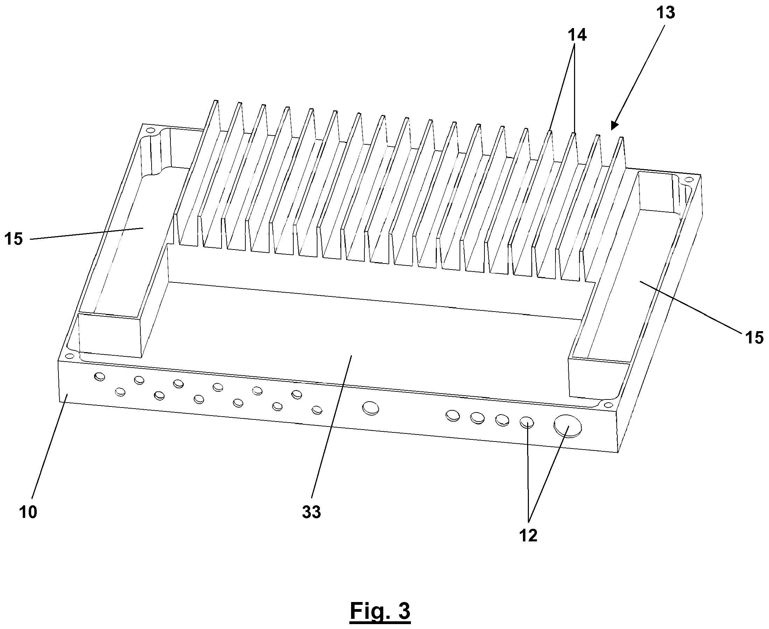

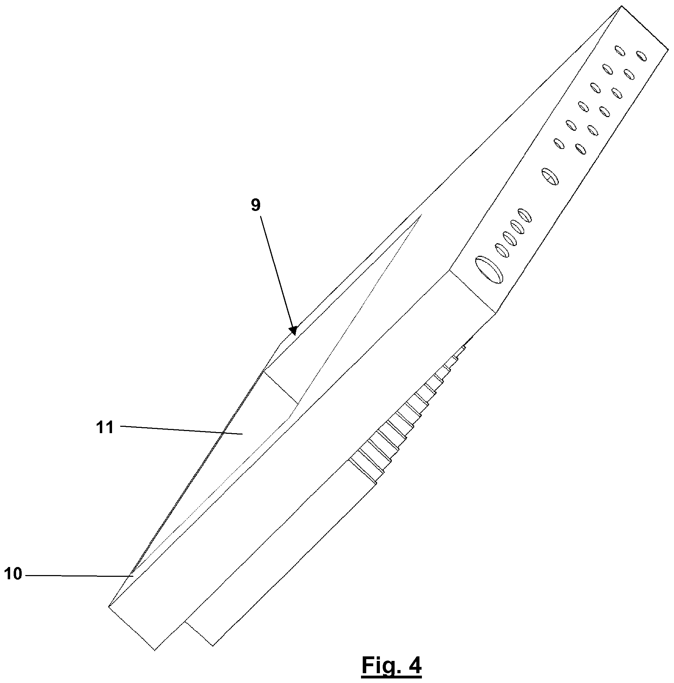

Das in den **Fig. 3** **und** **4** separat dargestellte erste Gehäusemodul 2 weist auf seiner in Fig. 3 gezeigten Vorderseite einen Kühlkörper 13 mit Kühlrippen 14 auf, die von dem Bereich des Grundkörpers 10 abstehen, der auf der Rückseite 9 gemäß Fig. 4 die Tasche 11 nach vorne begrenzt. Die in der Tasche 11 angeordneten Wickelkörper stehen über den Kühlkörper 13 dann in direktem thermischen Kontakt mit der Luft in dem Kühlluftkanal 6 gemäß den Fig. 1 und 2, in den der Kühlkörper 13 eingreift. Neben dem Kühlkörper 13 liegen Bereiche 15, die bei dem zusammengebauten Wechselrichter 1 gemäß den Fig. 1 und 2 gegenüber dem Kühlkanal 6 und auch der Umgebung 31 des Wechselrichters 1 abgedichtet sind.

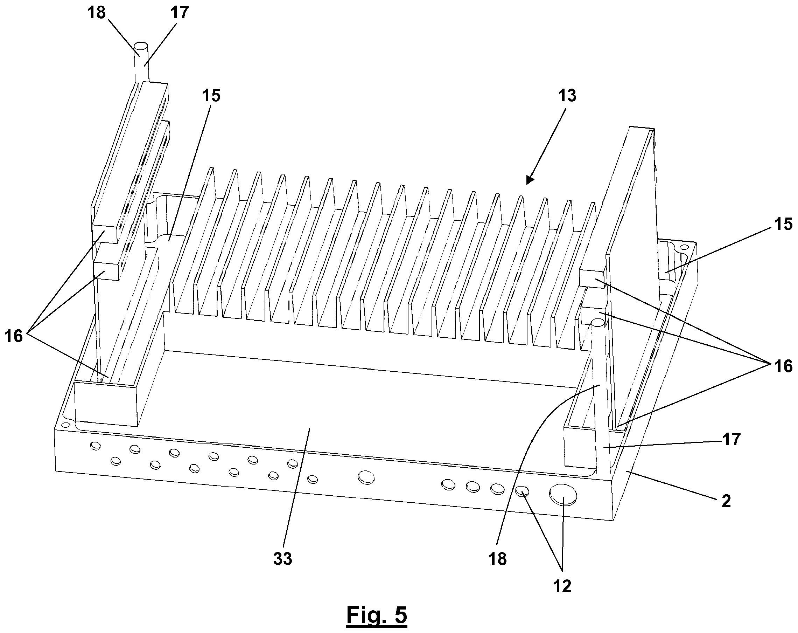

Gemäß **Fig. 5** sind in den Bereichen 15 Steckverbindungen 16 zur elektrischen Kontaktierung der in dem ersten Gehäusemodul 2 angeordneten leistungselektronischen Bauteile des Wechselrichters 1 mit in den anderen Gehäusemodulen 3 und 4 angeordneten leistungselektronischen Bauteilen des Wechselrichters 1 vorgesehen. Es liegt im Rahmen der Erfindung, dass in den die Bereiche 15 begrenzenden Wandungen des Gehäusemoduls 2 Öffnungen vorgesehen sind (in der Figur nicht eingezeichnet). Diese Öffnungen ermöglichen elektrische Verbindungen einerseits zwischen den in der Tasche 11 angeordneten Wickelkörpern und den Steckverbindungen 16 und andererseits zwischen Komponenten innerhalb eines an den Kühlluftkanal offen angrenzenden und von außen für elektrische Verbindungen durch die Öffnungen 12 zugänglichen Bereichs 33 und den Steckverbindungen 16. Sofern der Bereich 15 und die Tasche 11 im zusammengebauten Zustand des Wechselrichters 1 unterschiedliche Schutzklassen aufweisen, sind die elektrischen Verbindungen mit in den Öffnungen abgedichteten Kabeldurchführungen auszuführen, die im montierten Zustand die jeweils höhere Schutzklasse aufweisen. Analoges gilt für die elektrischen Verbindungen zwischen den Bereichen 15 und 33. Weiterhin zeigt Fig. 5 Linearführungen 17 in Form von Führungsstangen 18, die in Richtung des Stapels der Gehäusemodule 2 bis 4 von dem ersten, hinteren Gehäusemodul 2 abstehen.

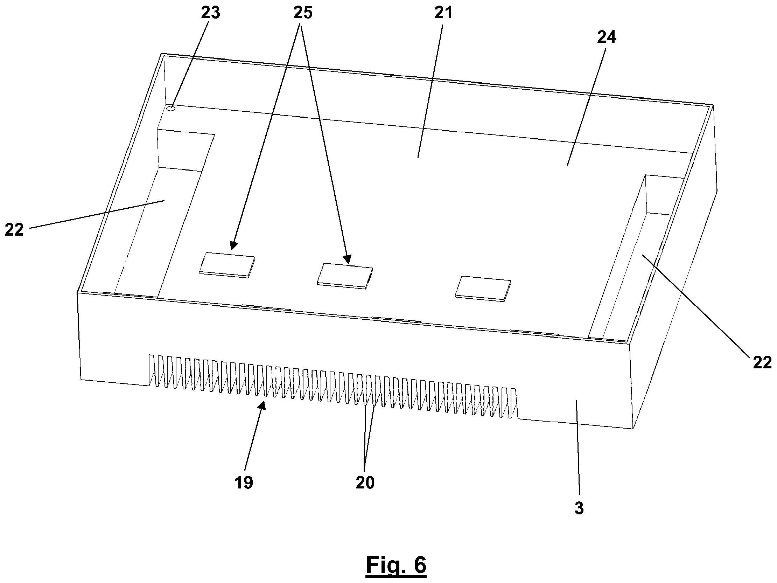

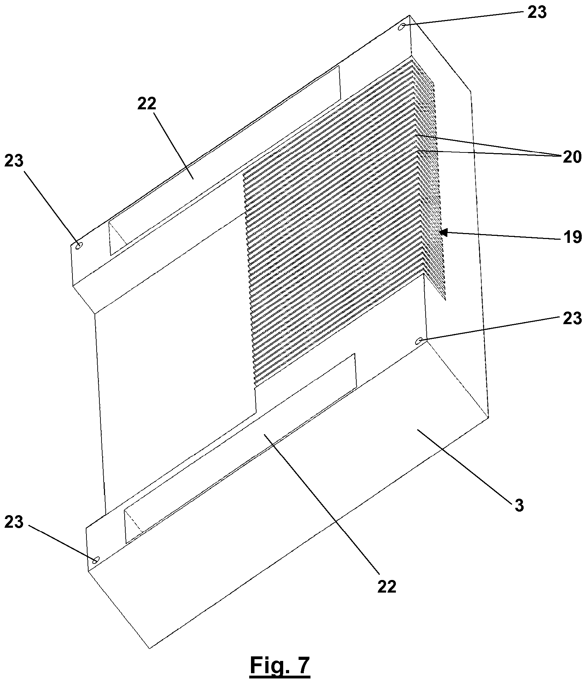

**Fig. 6** **und** **7** zeigen das zweite Gehäusemodul 3, das einen Kühlkörper 19 mit Kühlrippen 20 zum Eingriff in den Kühlluftkanal 6 gemäß Fig. 1 auf seiner Rückseite und einen gegenüber dem Kühlluftkanal 6 abgegrenzten Bereich 21 auf seiner Vorderseite aufweist. Der Bereich 21 geht nach hinten in Teilbereiche 22 über, die bei dem zusammengebauten Wechselrichter 1 mit den Bereichen 15 des ersten Gehäusemoduls 2 kommunizieren. Weiter umfasst das zweite Gehäusemodul 3 Löcher oder Führungsbuchsen 23 zur Führung des Gehäusemoduls 3 auf den Führungsstangen 18 gemäß Fig. 5. In dem Bereich 21 ist ein metallischer Grundkörper 24 des zweiten Gehäusemoduls 3 im Bereich von Aufnahmen 25 für thermisch an den Kühlluftkanal anzukoppelnde leistungselektronische Bauteile aufgedickt.

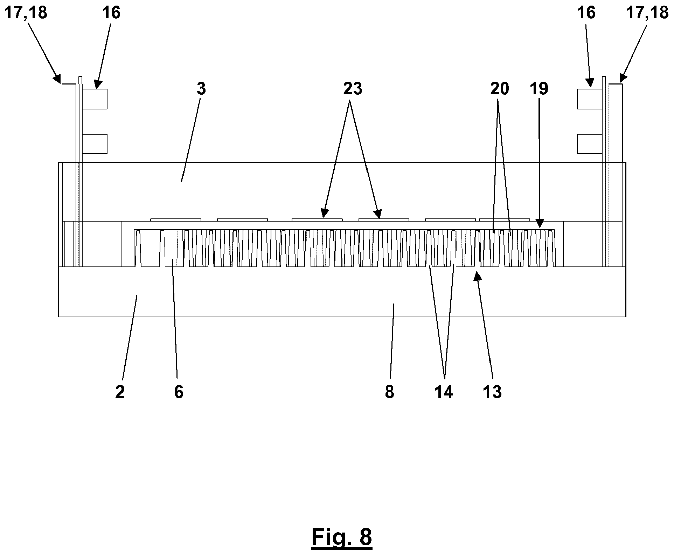

**Fig. 8** zeigt mit Blickrichtung auf die Seite 8 des Wechselrichters 1 das erste Gehäusemodul 2 und das daran angefügte zweite Gehäusemodul 3 mit den dadurch hindurchragenden Führungsstangen 18 und Steckverbindungen 16. Der Blick verläuft dabei längs der Durchströmungsrichtung des Kühlluftkanals 6, in den in Blickrichtung zunächst die Kühlrippen 14 des Kühlkörpers 13 von dem ersten Gehäusemodul 2 und dann die Kühlrippen 20 von dem Kühlkörper 19 des zweiten Gehäusemoduls 3 hineinragen.

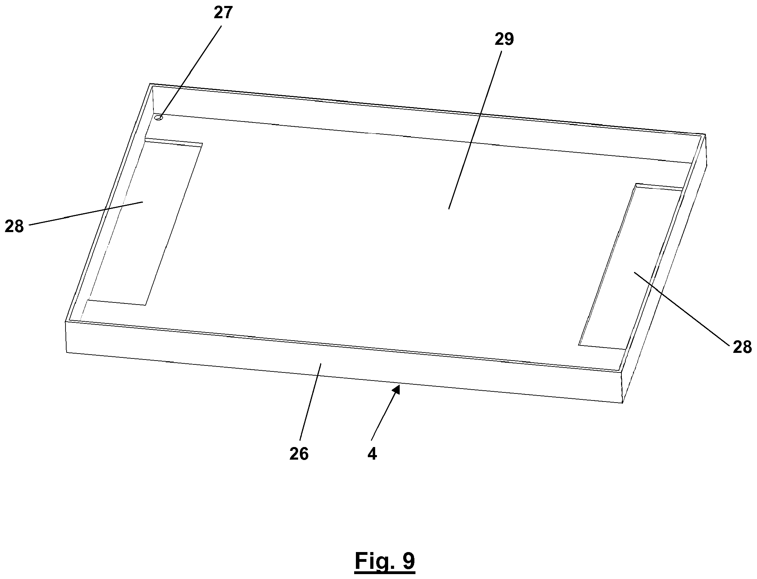

Das in **Fig. 9** dargestellte weitere Gehäusemodul 4 weist einen Grundkörper 26 auf, der Löcher oder Führungsbuchsen 27 für die Führungsstangen 18 gemäß Fig. 8 und Ausnehmungen 28 für die Steckverbindungen 16 aufweist und ansonsten auf seiner Vorderseite einen Bereich 29 umschließt. In diesem Bereich 29 können Bauteile des Wechselrichters 1 angeordnet werden, die keiner bzw. keiner ausgeprägten besonderen Kühlung bedürfen, weil sie nicht in direktem thermischen Kontakt mit dem Kühllüftkanal 6 gemäß Fig. 8 stehen. Hierbei ist das weitere Gehäusemodul 4 als optionales Bauteil innerhalb des Wechselrichters 1 zu verstehen. So kann der Wechselrichter 1 im Zusammenbau beispielsweise kein Gehäusemodul 4, nur ein, oder aber auch mehrere Gehäusemodule 4 aufweisen. Mit Hilfe dieser modularen Bauweise lässt sich zum Beispiel auf einfache Art und Weise die Anzahl von DC/DC-Wandlern oder von Zwischenkreiskondensatoren des Wechselrichters 1 variieren.

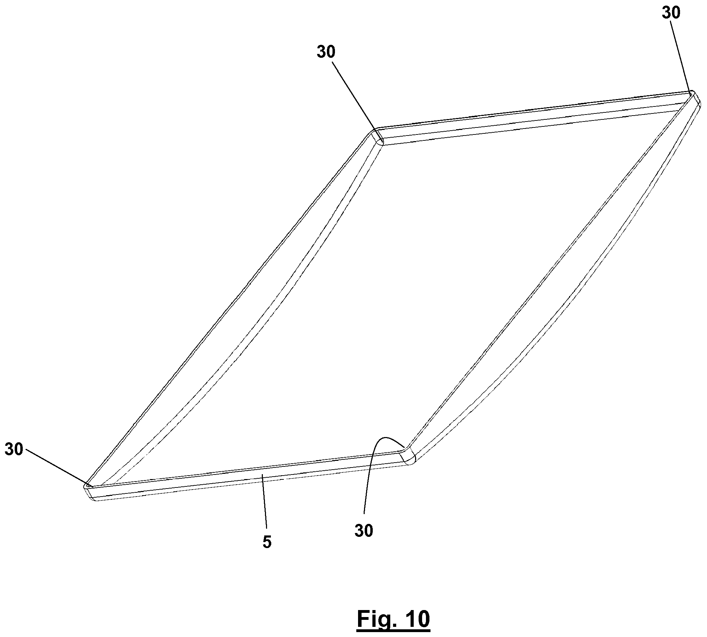

**Fig. 10** zeigt den Gehäusedeckel 5 des Wechselrichters 1. Dieser passt nicht nur wie in den Fig. 1 und 2 auf die weiteren Gehäusemodule 4, sondern auch direkt auf das zweite Gehäusemodul 3. Zur Vergrößerung des gegenüber der Umgebung 31 des Wechselrichters 1 abgeschlossenen Bereichs im Inneren des Wechselrichters ist der Gehäusedeckel 5 gewölbt ausgebildet. Der Gehäusedeckel 5 kann z. B. Fenster für ein Display des Wechselrichters oder Durchbrüche für Bedienelemente aufweisen. Der Gehäusedeckel 5 ist nicht mit Führungsöffnungen für die Führungsstangen 18 versehen. Jedoch können seine Ecken 30 auf den Führungsstangen 18 geführt sein, um ein definiertes Zusammenfügen des gesamten Wechselrichters 1 bis einschließlich des Gehäusedeckels 5 sicherzustellen.

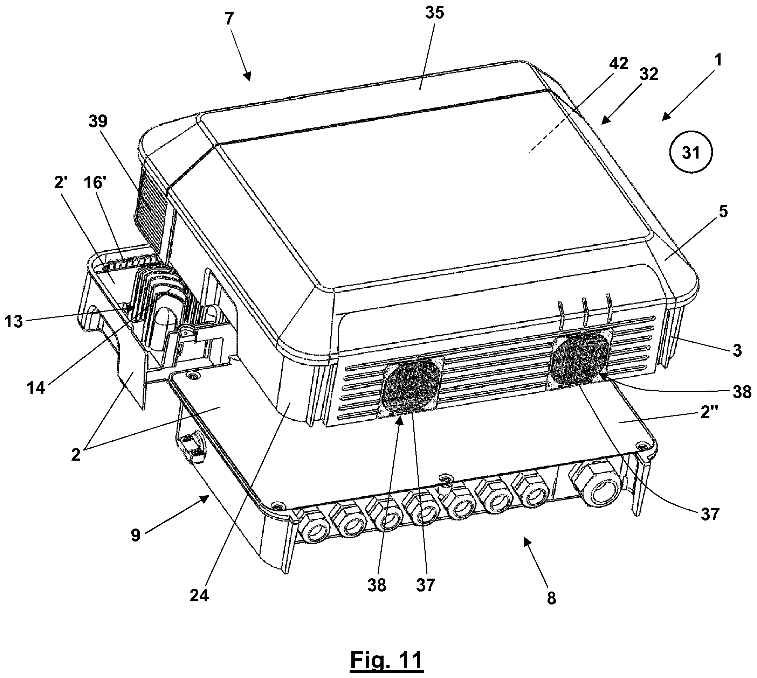

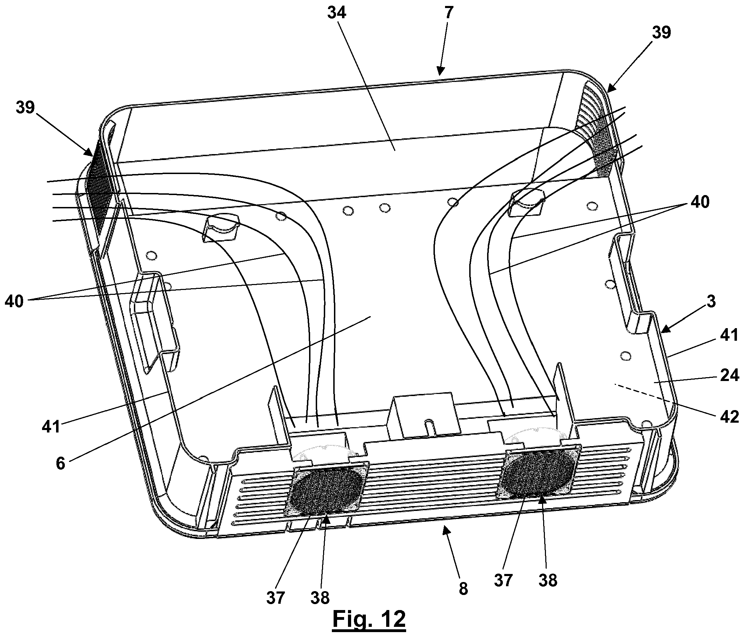

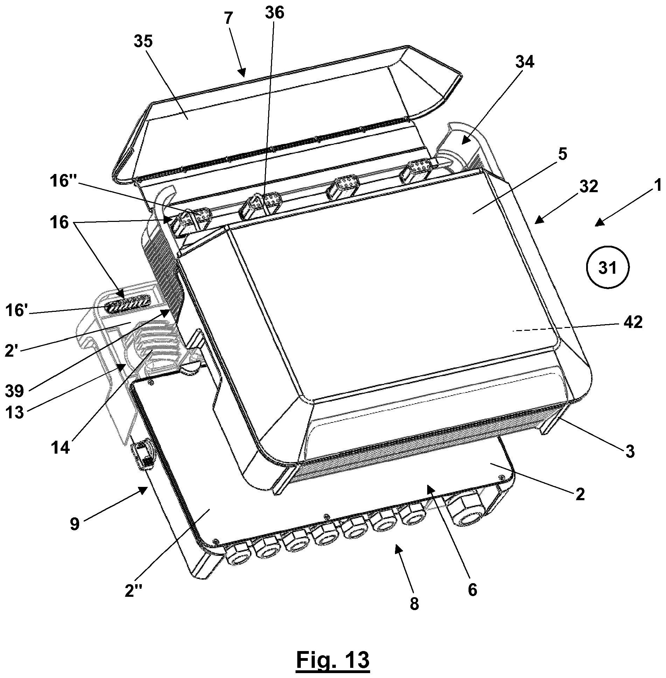

Die **Fig. 11-13** zeigen einen Wechselrichter 1, der sich in folgenden Details von dem Wechselrichter gemäß den Figuren 1 bis 10 unterscheidet. Das erste Gehäusemodul 2 ist seinerseits zweiteilig. Es umfasst einen Wickelkörper aufnehmenden Drosselteil 2' und einen elektrische Anschlüsse aufnehmenden Anschlussteil 2". Das zweite Gehäusemodul 3 umschließt einen zu dem ersten Gehäusemodul hin offenen Verbindungsbereich 34, der von einer klappbaren Schutzabdeckung 35 abgedeckt ist. Dabei sind die Steckverbindungen 16 aus ortsfest an dem Drosselteil 2' des ersten Gehäusemoduls 2 gelagerten Steckverbindern 16' und über Kabel 36 flexibel in dem Verbindungsbereich 34 an dem zweiten Gehäusemodul 3 gelagerten Steckverbindern 16" zusammengesetzt. Die Steckverbinder 16', 16" können ihrerseits im zusammengesteckten Zustand so weit abgedichtet sein, dass der Verbindungsbereich 34 durch die Schutzabdeckung nur vor direkter Einwirkung vor Niederschlag geschützt werden muss. Selbst wenn der Wechselrichter 1 im Außenbereich montiert wird, ist eine hohe IP-Schutzklasse des Verbindungsbereichs 34 nicht zwingend erforderlich, wenn sich die Steckverbinder 16', 16" im zusammengesteckten Zustand gegenseitig abdichten und Kabeldurchführungen der Steckverbinder 16', 16" in die angrenzenden Bereiche hoher IP-Schutzklasse entsprechend der jeweiligen IP-Schutzklasse ausgelegt sind. Der Kühlluftkanal 6 beginnt unten an der Seite 8 mit Lüftungsgittern 37, hinter denen Kühlluftgebläse 38 angeordnet sind, die nach oben zu der Seite 7 hin blasen. Der in den Fig. 11-13 dargestellte Fall mit zwei Kühlluftgebläsen 38 jeweils hinter einem separaten Lüftungsgitter 37 ist lediglich beispielhaft. So können auch weniger oder mehr als zwei Kühlluftgebläse 38 hinter separaten Lüftungsgittern 37 oder einem durchgehenden, sich über die gesamte Breite des Kühlluftkanals 6 erstreckenden Lüftungsgitter angeordnet sein. Oben an der Seite 7 ist das Gehäuse 1 jedoch geschlossen. Der Kühlluftkanal 6 endet hier vielmehr an seitlichen Lüftungsgittern 39. Eine durch Strömungslinien 40 angedeutete Durchströmung des Kühlluftkanals 6 knickt dadurch zur Seite ab; und der Kühlluftkanal 6 weist effektiv eine T- oder Y-Form auf. Dadurch wird verhindert, dass Niederschlag von der Seite 7, d. h. von oben in den Kühlluftkanal 6 eintritt und dadurch auf weitere Bauteile im Bereich des Kühlluftkanals 6, beispielsweise die Steckverbindungen 16 und/oder die Kühlluftgebläse 38 fällt. Die in den Kühlluftkanal 6 hinein ragenden Kühlkörper 13 weisen den Strömungslinien 40 entsprechend gekrümmte Kühlrippen 14 auf. Der Kühlluftkanal 6 erstreckt sich über die gesamte Breite des Gehäuses 1, d. h. er wird seitlich nur durch von dem zweiten Gehäusemodul nach hinten abstehende Wandungen 41 begrenzt. Hierbei können beide Gehäusemodule 2, 3 auch weitere Kühlkörper 13 mit in den Kühlluftkanal 6 hinein ragenden Kühlrippen 14 aufweisen, so beispielsweise auch in dem Bereich des Kühlluftkanals 6, der eine weitestgehend lineare Strömungsrichtung aufweist. Diese sind jedoch aus Gründen der Übersichtlichkeit in den Fig. 11 bis 13 nicht dargestellt. Ein die leistungselektronischen Bauteile des zweiten Gehäusemoduls 3 aufnehmender Bereich 42 ist zwischen dem zweiten Gehäusemodul 3 und dem Gehäusedeckel 5 abgedichtet, bereits bevor das zweite Gehäusemodul 3 mit dem ersten Gehäusemodul 2 verbunden ist. Um eine höhere IP-Schutzklasse in dem die leistungselektronischen Bauteile aufnehmenden Bereich 42 relativ zu dem Verbindungsbereich 34 zu gewährleisten, sind die Kabel 36 mit entsprechenden Dichtungen zu den Begrenzungswänden, durch die sie hindurchgeführt werden, hin abgedichtet.

### BEZUGSZEICHENLISTE

- 1: Wechselrichter
- 2: erstes Gehäusemodul
- 3: zweites Gehäusemodul
- 4: weiteres Gehäusemodul
- 5: Gehäusedeckel
- 6: Kühlluftkanal
- 7: Seite
- 8: Seite
- 9: Rückseite
- 10: Grundkörper
- 11: Tasche
- 12: Öffnung
- 13: Kühlkörper
- 14: Kühlrippe
- 15: Bereich
- 16: Steckverbindung
- 17: Linearführung
- 18: Führungsstange
- 19: Kühlkörper
- 20: Kühlrippe
- 21: Bereich
- 22: Teilbereich
- 23: Führungsbuchse
- 24: Grundkörper
- 25: Aufnahme
- 26: Grundkörper
- 27: Führungsbuchse
- 28: Durchbrechung
- 29: Bereich
- 30: Ecke
- 31: Umgebung
- 32: Gehäuse
- 33: Bereich
- 34: Verbindungsbereich
- 35: Schutzabdeckung
- 36: Kabel
- 37: Lüftungsgitter
- 38: Kühlluftgebläse
- 39: Lüftungsgitter
- 40: Strömungslinie
- 41: Wandung
- 42: Bereich

## Patentansprüche

1. Wechselrichter (1) mit
- einem Gehäuse (32), das
ein erstes Gehäusemodul (2),
ein mit dem ersten Gehäusemodul (2) lösbar verbundenes zweites Gehäusemodul (3) und
einen in die Umgebung (31) des Wechselrichters (1) mündenden Kühlluftkanal (6)
aufweist, und
- leistungselektronischen Bauteilen in dem ersten Gehäusemodul (2) und dem zweiten Gehäusemodul (3),
wobei der Kühlluftkanal (6) in Umfangsrichtung zum Teil von dem ersten Gehäusemodul (2) und zum Teil von dem zweiten Gehäusemodul (3) begrenzt wird, wobei das erste Gehäusemodul (2) zur Montage an einer externen Struktur und das zweite Gehäusemodul (3) zur ausschließlichen Montage an dem ersten Gehäusemodul (2) ausgebildet ist,
wobei der Kühlluftkanal (6) in einem Abstand zu einer von dem ersten Gehäusemodul (2) gegenüber der externen Struktur definierten Montageebene des Wechselrichters (1) verläuft, **dadurch gekennzeichnet,**
**dass** die leistungselektronischen Bauteile hinter den den Kühlluftkanal (6) begrenzenden Wandungen des ersten Gehäusemoduls (2) und des zweiten Gehäusemoduls (3) und damit geschützt in den Gehäusemodulen (2, 3) angeordnet sind..

2. Wechselrichter (1) nach Anspruch 1, **dadurch gekennzeichnet, dass** der Kühlluftkanal (6) in Umfangsrichtung geschlossen ist.

3. Wechselrichter (1) nach Anspruch 1 oder 2, **dadurch gekennzeichnet, dass** das erste Gehäusemodul (2) und/oder das zweite Gehäusemodul (3) mindestens einen in den Kühlluftkanal (6) vorspringenden Kühlkörper (13, 19) umfassen, mit dem eines oder mehrere der leistungselektronischen Bauteile in thermischem Kontakt stehen.

4. Wechselrichter (1) nach einem der vorhergehenden Ansprüche, **dadurch gekennzeichnet, dass** das erste Gehäusemodul (2) und/oder das mit dem ersten Gehäusemodul (2) lösbar verbundene zweite Gehäusemodul (3), optional zusammen mit weiteren Gehäusemodulen (4), mindestens einen Bereich (15, 21, 22, 29, 42) für eines oder mehrere der leistungselektronischen Bauteile gegenüber der Umgebung (31) des Wechselrichters (1) abdichtet bzw. abdichten.

5. Wechselrichter (1) nach einem der vorhergehenden Ansprüche, **dadurch gekennzeichnet, dass** zwischen dem ersten Gehäusemodul (2) und dem zweiten Gehäusemodul (3) mindestens eine Dichtung zum Abdichten mindestens eines zusammenhängenden Bereichs (15, 22, 21) gegenüber der Umgebung (31) angeordnet ist, der teilweise in dem ersten Gehäusemodul (2) und teilweise in dem zweiten Gehäusemodul (3) liegt, wobei der mindestens eine zusammenhängende Bereich bevorzugt ein sich durch das erste Gehäusemodul (2) und das zweite Gehäusemodul (3) erstreckender Kühlmittelkanal für ein flüssiges Kühlmittel ist.

6. Wechselrichter (1) nach einem der vorhergehenden Ansprüche, **dadurch gekennzeichnet, dass** zwischen dem ersten Gehäusemodul (2) und dem zweiten Gehäusemodul (3) elektrische Steckverbindungen (16) zur wechselseitigen Kontaktierung der leistungselektronischen Bauteile in den beiden Gehäusemodulen (2, 3) vorgesehen sind.

7. Wechselrichter (1) nach einem der vorhergehenden Ansprüche, **dadurch gekennzeichnet, dass** zwischen dem ersten Gehäusemodul (2) und dem zweiten Gehäusemodul (3) mechanische Linearführungen (17) zur wechselseitigen Ausrichtung beim linearen Zusammenfügen der Gehäusemodule (2, 3) vorgesehen sind.

8. Wechselrichter (1) nach einem der vorhergehenden Ansprüche, **dadurch gekennzeichnet, dass** in dem ersten Gehäusemodul (2) DC-Anschlüsse und/oder DC-Trennschalter und/oder AC-Anschlüsse und/oder AC-Trennschalter und/oder Wickelgüter angeordnet sind.

9. Wechselrichter (1) nach einem der vorhergehenden Ansprüche, **dadurch gekennzeichnet, dass** in dem zweiten Gehäusemodul (3) Platinen einer Leistungselektronik und/oder Schalter einer Wechselrichterbrücke und/oder Platinen einer Steuerelektronik angeordnet sind.

10. Wechselrichter (1) nach einem der vorhergehenden Ansprüche, **dadurch gekennzeichnet, dass** das erste Gehäusemodul (2) und/oder das zweite Gehäusemodul (3) einen Grundkörper (10, 24) aus Metall aufweist, der jeweils seinen den Kühlluftkanal begrenzenden Teil umfasst.

11. Wechselrichter (1) nach einem der vorhergehenden Ansprüche, **dadurch gekennzeichnet, dass** an das zweite Gehäusemodul (3), auf seiner dem ersten Gehäusemodul (2) gegenüberliegenden Seite mindestens ein weiteres Gehäusemodul (4) angrenzt.

12. Wechselrichter (1) nach Anspruch 10, **dadurch gekennzeichnet, dass** mindestens zwei weitere Gehäusemodule (4) mit identischen Grundkörpern (26) auf das zweite Gehäusemodul (3) gestapelt sind.

13. Wechselrichter (1) nach einem der Ansprüche 10 bis 12, **dadurch gekennzeichnet, dass** der Stapel der Gehäusemodule (2 bis 4) von einem Gehäusedeckel (5) abgeschlossen wird.

14. Wechselrichter (1) nach einem der vorhergehenden Ansprüche, **dadurch gekennzeichnet, dass** der Kühlluftkanal (6) an einem von mindestens zwei in die Umbebung (31) des Wechselrichters (1) mündenden Enden mit mindestens einem Kühlluftgebläse (38) versehen ist.

15. Wechselrichter (1) nach Anspruch 14, **dadurch gekennzeichnet, dass** sich der Kühlluftkanal (6) im montierten Zustand Y- oder T-förmig nach oben verzweigt, wobei das Kühlluftgebläse (38) an seinem unteren Ende vorgesehen ist und seine beiden oberen Enden seitlich an dem Gehäuse (32) liegen, und wobei insbesondere elektrische Verbindungen zwischen dem ersten Gehäusemodul (2) und/oder dem zweiten Gehäusemodul (3) in einem abgedeckten Verbindungsbereich (34) im montierten Zustand oberhalb des Kühlluftkanals (6) angeordnet sind.

16. Wechselrichter (1) nach einem der vorhergehenden Ansprüche, **dadurch gekennzeichnet, dass** sich der Kühlluftkanal (6) in seiner Breite über mehr als zwei Drittel der Breite des Gehäuses (32) erstreckt.

## Claims

1. An inverter (1) comprising
- a housing (32), containing
a first housing module (2),
a second housing module (3), which is connected detachably to the first housing module (2), and
a cooling air channel (6), which opens out into the surrounding environment (31) of the inverter (1), and
- power electronics component parts in the first housing module (2) and the second housing module (3),
wherein the cooling air channel (6) is delimited in a circumferential direction partially by the first housing module (2) and partially by the second housing module (3),
wherein the first housing module (2) is designed for mounting to an external structure, and the second housing module (3) is designed for an exclusive mounting to the first housing module (2),
wherein the cooling air channel (6) extends with a spacing from a mounting plane of the inverter (1), which mounting plane is defined by the first housing module (2) with respect to the external structure, **characterized**
**in that** the power electronics component parts are arranged behind walls of the first housing module (2) and the second housing module (3), which walls delimit the cooling air channel (6) such that the power electronics component parts are protectively arranged in the housing modules (2, 3).

2. The inverter (1) as claimed in claim 1, **characterized in that** the cooling air channel (6) is closed in circumferential direction.

3. The inverter (1) as claimed in claim 1 or 2, **characterized in that** the first housing module (2) and/or the second housing module (3) comprise at least one cooling body (13, 19), which projects into the cooling air channel (6) and with which one or more of the power electronics component parts are in thermal contact.

4. The inverter (1) as claimed in one of the preceding claims, **characterized in that** the first housing module (2) and/or the second housing module (3), which is connected detachably to the first housing module (2), optionally together with further housing modules (4), seals or seal off at least one region (15, 21, 22, 29, 42) for one or more of the power electronics component parts with respect to the surrounding environment (31) of the inverter (1).

5. The inverter (1) as claimed in one of the preceding claims, **characterized in that** at least one seal for sealing off at least one coherent region (15, 22, 21) with respect to the surrounding environment (31) is arranged between the first housing module (2) and the second housing module (3), which coherent region (15, 22, 21) being partially in the first housing module (2) and partially in the second housing module (3) and wherein the at least one coherent region preferably is a coolant channel for a liquid coolant which coolant channel extends through the first housing module (2) and the second housing module (3).

6. The inverter (1) as claimed in one of the preceding claims, **characterized in that** electrical plug-type connections (16) for making alternate contact with the power electronics component parts in the two housing modules (2, 3) are provided between the first housing module (2) and the second housing module (3).

7. The inverter (1) as claimed in one of the preceding claims, **characterized in that** mechanical linear guides (17) for alternate orientation when the housing modules (2, 3) are assembled linearly are provided between the first housing module (2) and the second housing module (3).

8. The inverter (1) as claimed in one of the preceding claims, **characterized in that** DC connections and/or DC switch disconnectors and/or AC connections and/or AC switch disconnectors and/or winding materials are arranged in the first housing module (2).

9. The inverter (1) as claimed in one of the preceding claims, **characterized in that** circuit boards of power electronics and/or switches of an inverter bridge and/or circuit boards of control electronics are arranged in the second housing module (3).

10. The inverter (1) as claimed in one of the preceding claims, **characterized in that** the first housing module (2) and/or the second housing module (3) comprises a basic body (10, 24) consisting of metal, which basic body (10, 24) in each case comprises that part of said housing module(s) which delimits the cooling air channel.

11. The inverter (1) as claimed in one of the preceding claims, **characterized in that** at least one further housing module (4) adjoins the second housing module (3) on its side opposite the first housing module (2).

12. The inverter (1) as claimed in claim 10, **characterized in that** at least two further housing modules (4) with identical basic bodies (26) are stacked onto the second housing module (3).

13. The inverter (1) as claimed in claim 10 to 12, **characterized in that** the stack of housing modules (2 to 4) is closed off by a housing cover (5).

14. The inverter (1) as claimed in one of the preceding claims, **characterized in that** the cooling air channel (6) is provided with at least one cooling air fan (38) at one of at least two ends opening out into the surrounding environment (31) of the inverter (1).

15. The inverter (1) as claimed in claim 14, **characterized in that** in an assembled state the cooling air channel (6) branches upwards in the form of a Y or T, wherein the cooling air fan (38) is provided at its lower end, and its two upper ends are located laterally on the housing (32), and wherein in particular electrical connections between the first housing module (2) and/or the second housing module (3) are arranged in a covered connecting region (34) above the cooling air channel (6).

16. The inverter (1) as claimed in one of the preceding claims, **characterized in that** the cooling air channel (6) extends in terms of its width over more than two thirds of the width of the housing (32).

## Revendications

1. Onduleur (1) comportant
- un boîtier (32), comprenant
un premier module de boîtier (2),
un deuxième module de boîtier (3) relié de manière amovible au premier module de boîtier (2) et
un canal d'air de refroidissement (6) débouchant dans l'environnement (31) de l'onduleur (1), et
- des composants électroniques de puissance situés dans le premier module de boîtier (2) et le deuxième module de boîtier (3),
dans lequel le canal d'air de refroidissement (6) est délimité en partie par le premier module de boîtier (2) et en partie par le deuxième module de boîtier (3) dans la direction circonférentielle,
dans lequel le premier module de boîtier (2) est conçu pour être monté au niveau d'une structure externe et le deuxième module de boîtier (3) est conçu pour être monté exclusivement au niveau du premier module de boîtier (2),
dans lequel le canal d'air de refroidissement (6) s'étend à une certaine distance du plan de montage de l'onduleur (1), défini par le premier module de boîtier (2) par rapport à la structure externe,
**caractérisé en ce que** les composants électroniques de puissance sont disposés à l'arrière des parois du premier module de boîtier (2) et du deuxième module de boîtier (3) qui délimitent le canal d'air de refroidissement (6) et de manière à ce qu'ils soient ainsi protégés dans les modules de boîtier (2, 3).

2. Onduleur (1) selon la revendication 1, **caractérisé en ce que** le canal d'air de refroidissement (6) est fermé dans la direction circonférentielle.

3. Onduleur (1) selon la revendication 1 ou 2, **caractérisé en ce que** le premier module de boîtier (2) et/ou le deuxième module de boîtier (3) comprend/comprennent au moins un corps de refroidissement (13, 19) faisant saillie dans le canal d'air de refroidissement (6), avec lequel l'un ou plusieurs des composants électroniques de puissance sont en contact thermique.

4. Onduleur (1) selon l'une quelconque des revendications précédentes, **caractérisé en ce que** le premier module de boîtier (2) et/ou le deuxième module de boîtier (3) relié de manière amovible au premier module de boîtier (2), et facultativement, en association avec d'autres modules de boîtier (4), étanchéifie/étanchéifient au moins une zone (15, 21, 22, 29, 42) destinée à un ou plusieurs des composants électroniques de puissance par rapport à l'environnement (31) de l'onduleur (1).

5. Onduleur (1) selon l'une quelconque des revendications précédentes, **caractérisé en ce que**, entre le premier module de boîtier (2) et le deuxième module de boîtier (3), est disposé au moins un élément d'étanchéité destiné à étanchéifier au moins une zone solidaire (15, 22, 21) par rapport à l'environnement (31), qui se situe en partie dans le premier module de boîtier (2) et en partie dans le deuxième module de boîtier (3), dans lequel l'au moins une zone solidaire est de préférence un canal d'agent de refroidissement destiné à un agent de refroidissement liquide s'étendant à travers le premier module de boîtier (2) et le deuxième module de boîtier (3).

6. Onduleur (1) selon l'une quelconque des revendications précédentes, **caractérisé en ce qu'**il est prévu entre le premier module de boîtier (2) et le deuxième module de boîtier (3) des connexions électriques (16) destinées à une mise en contact mutuelle des composants électroniques de puissance dans les deux modules de boîtier (2, 3).

7. Onduleur (1) selon l'une quelconque des revendications précédentes, **caractérisé en ce qu'**il est prévu entre le premier module de boîtier (2) et le deuxième module de boîtier (3) des guides mécaniques linéaires (17) destinés à un alignement mutuel lors de l'assemblage linéaire des modules de boîtier (2, 3).

8. Onduleur (1) selon l'une quelconque des revendications précédentes, **caractérisé en ce que** des bornes à courant continu et/ou des disjoncteurs à courant continu et/ou des bornes à courant alternatif et/ou des disjoncteurs à courant alternatif et/ou des produits bobinés sont disposés dans le premier module de boîtier (2).

9. Onduleur (1) selon l'une quelconque des revendications précédentes, **caractérisé en ce que** des cartes d'une électronique de puissance et/ou des commutateurs d'un pont redresseur d'un pont d'onduleur et/ou des cartes d'une électronique de commande sont disposés dans le deuxième module de boîtier (3).

10. Onduleur (1) selon l'une quelconque des revendications précédentes, **caractérisé en ce que** le premier module de boîtier (2) et/ou le deuxième module de boîtier (3) comprend/comprennent un corps de base (10, 24) constitué de métal, qui comprend respectivement sa partie délimitant le canal d'air de refroidissement.

11. Onduleur (1) selon l'une quelconque des revendications précédentes, **caractérisé en ce qu'**au moins un autre module de boîtier (4) est adjacent au deuxième module de boîtier (3), sur son côté qui est opposé au premier module de boîtier (2).

12. Onduleur (1) selon la revendication 10, **caractérisé en ce qu'**au moins deux autres modules de boîtier (4) ayant des corps de base identiques (26) sont empilés sur le deuxième module de boîtier (3).

13. Onduleur (1) selon l'une quelconque des revendications 10 à 12, **caractérisé en ce que** l'empilement des modules de boîtier (2 à 4) est fermé par un capot de boîtier (5).

14. Onduleur (1) selon l'une quelconque des revendications précédentes, **caractérisé en ce que** le canal d'air de refroidissement (6) est muni sur l'une d'au moins deux extrémités débouchant dans l'environnement (31) de l'onduleur (1), d'au moins un ventilateur d'air de refroidissement (38).

15. Onduleur (1) selon la revendication 14, **caractérisé en ce que** le canal d'air de refroidissement (6) à l'état monté se ramifie vers le haut en forme de Y ou de T, dans lequel le ventilateur d'air de refroidissement (38) est prévu à son extrémité inférieure et ses deux extrémités supérieures sont situées latéralement au niveau du boîtier (32), et dans lequel des connexions électriques entre le premier module de boîtier (2) et/ou le deuxième module de boîtier (3) sont notamment disposées à l'état monté au-dessus du canal d'air de refroidissement (6) dans une zone de connexion recouverte (34).

16. Onduleur (1) selon l'une quelconque des revendications précédentes, **caractérisé en ce que** le canal d'air de refroidissement (6) s'étend dans le sens de sa largeur sur plus d'un tiers de la largeur du boîtier (32).
